# EUROPÄISCHE PATENTSCHRIFT

(11) **EP 1 740 331 B1**
(45) Veröffentlichungstag und Bekanntmachung des Hinweises auf die Patenterteilung: **29.07.2009**
(21) Anmeldenummer: 05742309.7
(22) Anmeldetag: 12.04.2005
(51) Int. Cl.: B22D 1/00, B22D 27/04

(54) **VERFAHREN UND ANORDNUNG ZUR KRISTALLZÜCHTUNG AUS METALLISCHEN SCHMELZEN ODER SCHMELZLÖSUNGEN**
METHOD AND ARRANGEMENT FOR CRYSTAL GROWTH FROM FUSED METALS OR FUSED SOLUTIONS
PROCEDE ET SYSTEME DE CRISTALLISATION A PARTIR DE MASSES OU SOLUTIONS DE MASSES EN FUSION METALLIQUES

(30) Priorität: 13.04.2004 DE 102004018664
(43) Veröffentlichungstag der Anmeldung: 10.01.2007
(73) Patentinhaber: Helmholtz-Zentrum Berlin für Materialien und Energie GmbH, 14109 Berlin (DE)
(72) Erfinder: MECKLENBURG, Arno, 10999 Berlin (DE); FIECHTER, Sebastian, 14109 Berlin (DE); NABEIN, Hans-Peter, 12207 Berlin (DE); SCHNEIDER, Rainer Peter, 12165 Berlin (DE)
(74) Vertreter: Rudolph, Margit
(86) Internationale Anmeldenummer: PCT/DE2005/000694
(87) Internationale Veröffentlichungsnummer: WO 2005/099934

(56) Entgegenhaltungen:
- EP-A- 0 922 618
- EP-A- 0 927 777
- DE-C1- 19 960 362
- GB-A- 1 205 028
- JP-A- 06 345 581
- JP-A- 55 140 792
- HOLZGRUBER W: "ELECTROSLAG REMELTING - A SUMMARY OF THE STATE OF THE PROCESS" STEEL TIMES, FUEL & METALLURGICAL JOURNALS LTD. LONDON, GB, Bd. 219, Nr. 1, Januar 1991 (1991-01), Seite 32,34, XP000173497 ISSN: 0039-095X
- KOCH K. UND JANKE D. (ED.): "Schlacken in der Metallurgie" 1984, STAHLEISEN , DÜSSELDORF, DEUTSCHLAND , XP002355348 Seiten 297-311 "Schlacken für das Elektro-Schlacke-Umschmelzverfahren"
- WHITE C H ET AL: "CLEANER SUPERALLOYS IMPROVED MELTING PRACTICES" ADVANCED MATERIALS & PROCESSES, AMERICA SOCIETY FOR METALS. METALS PARK, OHIO, US, Bd. 137, Nr. 4, 1. April 1990 (1990-04-01), Seiten 53-57, XP000126057 ISSN: 0882-7958
- T.DUFFAR, P.DUSSERRE, F.PICCA, S.LACROIIX, N. GIACOMETTI: "Bridgman growth without crucible contact using dewetting phenomenon" JOURNAL OF CRYSTAL GROWTH, Bd. 211, Nr. 1-4, 1. April 2000 (2000-04-01), Seiten 434-440, XP004193415 Elsevier Science Amsterdam

## Beschreibung

Die Erfindung betrifft ein Verfahren zur Züchtung von einkristallinen Metallen, intermetallischen Verbindungen und Legierungen aus metallischen Schmelzen oder Schmelzlösungen, wobei die Kristallisation nach bekannten Verfahren erfolgt und als Ausgangsmaterialien Metalle oder intermetallischen Verbindungen oder Legierungen verwendet werden.

Dem Stand der Technik nach allgemein bekannt ist das Elektroschlacke-Umschmelzverfahren (ESU), bei dem unter kontrollierten Bedingungen bezüglich Schmelzrate und Atmosphäre unter einem Schlackefilm eine Elektrode in einem gekühlten Kristallisator umgeschmolzen wird. Die umzuschmelzenden Elektroden stammen aus Primärschmelzen des Block- oder Stranggusses. Die erhaltenen Blöcke weisen nun eine größere Reinheit auf. Während des Aufschmelzens der Elektrode lösen sich ständig Metalltröpfchen von der Spitze der Elektrode, die im intensiven Kontakt mit dem Schlackefilm auf der Oberfläche der Schmelze von nichtmetallischen Verunreinigungen gereinigt werden (s. beispielsweise STEEL TIMES, FUEL & METALLURGICAL JOURNALS LTD. LONDON, GB, BD. 219, Nr. 1, Januar 1991 (1991-1), Seite 32-34).

In "Schlacken in der Metallurgie" 1984, STAHLEISEN, DÜSSELDORF, DEUTSCHLAND, Seiten 297-311, wird die Rolle der Schlacke im ESU-Verfahren, die sich immer auf der Oberfläche der Schmelze befindet, beschrieben.

Weiterhin bekannt sind Verfahren zur Züchtung von Halbleitereinkristallen mittels VGF(vertical gradient freeze)-Methode bekannt, bei denen das gemischte Material in einem Tiegel aufgeschmolzen wird. Ein definierter Temperaturgradient entlang des Tiegels bewirkt die Kristallisation, beginnend mit einem Keimkristall. Die Schmelze wird mit einer Boroxid-Schmelze abgedeckt, die eine Veränderung der Zusammensetzung der Schmelze durch Abdampfen der Komponente mit höherem Dampfdruck verhindern sowie die Schmelze von oxidierbaren Verunreinigungen reinigen soll (s. beispielsweise JP 06 345581 A; JP 55 140792 A; EP-A-0 927 777; EP-A-0 992 618).

Bei der Herstellung von Ni-Mn-Ga-Kristallen ist es bekannt, die Reinmetalle in Bogenöfen aufzuschmelzen, wobei wegen des hohen Dampfdruckes des Mangans erhebliche Mengen Mangan verloren gehen. Anschließend wird das erstarrte Metall aufgeschmolzen und nach D. L. Schlagel, Z. L. Wu, W. Zhang, T. A. Lograsso, Jounal of Alloys and Compound 312 (2000) 77-85 und S. J. Murray, M. Marioni, S. M. Allen, R.C. O'Handley, Applied Physics Letters (2000) Vol.77 No.6 im Bridgman- oder nach W. H. Wang, Z. H. Liu, Z. W. Shan, J. L. Chen, G. H. Wu, W. S. Zhan, J. Phys. D: Appl. Phys. 35 (2002) 492-496 im Czochralskiverfahren kristallisiert.
Während dieses Prozessschrittes geht ebenfalls Mangan verloren. Ein weiterer Nachteil der bekannten Verfahren ist die Bildung von Poren und Einschlüssen. Diesem Problem wurde bisher mit wiederholtem Aufschmelzen begegnet. Auch bei diesem Prozessschritt geht Mangan verloren.

Aufgabe der Erfindung ist ein einfaches Verfahren und eine Anordnung zur Kristallzüchtung aus metallischen Schmelzen oder Schmelzlösungen und Kristallisation nach bekannten Verfahren, die die Herstellung großer poren- und einschlussfreier Einkristalle aus Metallen sowie intermetallischen Verbindungen und Legierungen ermöglichen.

Beim Verfahren zur Kristallzüchtung aus metallischen Schmelzen oder Schmelzlösungen, wobei die Kristallisation nach bekannten Verfahren erfolgt und als Ausgangsmaterialien der metallischen Schmelzen oder Schmelzlösungen Metalle oder intermetallischen Verbindungen oder Legierungen verwendet werden, wird diese Aufgabe erfindungsgemäß dadurch gelöst, dass die Ausgangsmaterialien mit einem schlackebildenden, gegen die metallische Schmelze chemisch inerten Flussmittel innig in Kontakt gebracht und vollständig aufgeschmolzen, wobei die Zusammensetzung des Flussmittels derart auf das jeweilige System Kristallzüchtungstiegel - Schmelze abgestimmt wird, dass die sich bildende Schlacke den Tiegel benetzt und zwischen metallischer Schmelze und Kristallzüchtungstiegel einen geschlossenen dünnen Film bildet.

Erfindungsgemäß können schlackebildende Flussmittel und Metalle oder intermetallischen Verbindungen oder Legierungen hierbei in festem Zustand gemischt und im Kristallzüchtungstiegel aufgeschmolzen oder voneinander räumlich getrennt aufgeschmolzen und nacheinender in den Kristallzüchtungstiegel gegeben werden.

In Ausgestaltung der Erfindung wird bei getrennter Aufschmelzung das schlackebildende Flussmittel vorzugsweise im Tiegel vorgelegt und die metallische Schmelze hinzu gegossen.

Die eingesetzten Metalle oder intermetallischen Verbindungen oder Legierungen können als Pulver, Granulat o.ä. vorliegen.

Beim Aufschmelzen eines pulverförmigen Gemisches aus Metall/Metallen oder intermetallischen Verbindungen oder Legierungen und schlackebildendem Flussmittel, ist es vorteilhaft, dieses zuvor zu verdichten.

In Ausgestaltung der Erfindung wird die Temperatur der Schmelze hinreichend lange konstant gehalten.

In weiterer Ausgestaltung kann die Schmelze *in situ* erstarrt und wieder aufgeschmolzen werden.

Erfindungsgemäß kann der Bestandteil der Metalle oder intermetallischen Verbindungen oder Legierungen, der einen niedrigeren Solidus besitzt als das schlackebildende Flussmittel, nach dem Aufschmelzen der übrigen Bestandteile auf die erstarrte Schlacke gegeben und das Kristallzüchtungsgefäß unter einer inerten Atmosphäre derart erhitzt werden dass die Schlacke eine Deckschicht auf der metallischen Schmelze bildet, unter der alle metallischen Bestandteile verschmelzen.

Die inerte Atmosphäre kann erfindungsgemäß ein verminderter Druck (Vakuum) sein.

Nach der Erfindung wird die Zusammensetzung des schlackebildenden Flussmittels auf das jeweilige System abgestimmt.

Erfindungsgemäß soll die Schlacke ein hohes Lösungsvermögen für die jeweiligen, zumeist oxidischen, Verunreinigungen besitzen und die Dichte kleiner als die der metallischen Schmelze oder Schmelzlösung sein - die Schlacke muss gut seigem. Die Dichte der Schlacke sollte nicht zu gering sein, damit die Entmischung von Schlacke und Metall nicht zu rasch erfolgt, es sei denn, wichtige andere Aspekte der jeweiligen Aufgabe, beispielsweise die Maßhaltigkeit beim Einkristall-Feinguss, stehen dem entgegen.

Wenigstens der Solidus der Schlacke soll kleiner als der Schmelzpunkt bzw. die Schmelzpunkte der in der metallischen Schmelze oder Schmelzlösung enthaltenen Metalle und kleiner als der Solidus der zu kristallisierenden metallischen Schmelze oder Schmelzlösung sein.

In Ausgestaltung ist die Viskosität der Schlacke an die jeweilige Aufgabe angepasst.

Nach der Erfindung sind Halogenide, Oxide, Silikate, Borate, Phosphate Flussmittelbestandteile.

Zur Züchtung von Ni-Mn-Ga-Einkristallen ist es zweckmäßig, dass das schlackebildende Flussmittel aus 55at% MgF₂, 35at% CaF₂ und 10at%CaO besteht.

In Ausgestaltungen der Erfindung ist vorgesehen, dass der Temperaturgradient beim Erstarren mittels eines bewegbaren Kristallzüchtungstiegels, mittels bewegbarer oder elektrisch steuerbarer Heizelemente eingestellt wird.

Das wichtigste erfindungsgemäße Merkmal ist die Verwendung eines schlackebildenden Flussmittels, das nicht mit der metallischen Schmelze reagieren darf. Es muss also chemisch inert gegen die metallische Schmelze sein.

Das schlackebildende Flussmittel muss ein gutes Lösungsvermögen für störende Verunreinigungen besitzen. Wird ein pulverförmiges Gemisch aus Metall oder intermetallischen Verbindungen oder Legierungen und schlackebildendem Flussmittel aufgeschmolzen, werden die Metallpulver durch das Flussmittel von anhaftenden Verunreinigungen, insbesondere Oxiden, befreit. Das schlackebildende Flussmittel verbessert so den Kontakt zwischen den Metallen, wodurch die notwendigen Prozesstemperaturen erheblich herabsetzt werden können, und die Bildung von Poren und Einschlüssen durch im Flussmittel lösliche Verunreinigungen oder nicht aufgeschmolzenes Metall vermieden wird. Die aus Flussmittel und Verunreinigungen gebildete Schlacke bedeckt nach dem Schmelzen die metallische Schmelze und verhindert das Abdampfen von Metallen. Aus den durch schlackebildende Flussmittel aufgereinigten Schmelzen können große Kristalle einfacher erhalten werden, da in diesen Schmelzen weitaus weniger Verunreinigungen vorhanden sind, welche als Nukleationszentren fungieren können.

Von großer Bedeutung für die Erfindung ist die Wirkung der Schlacke im Zusammenhang mit dem Tiegel. Wenn die Schlacke den Tiegel gut benetzt, kann ein geschlossener, flüssiger Schlackefilm zwischen metallischer Schmelze und Tiegel gebildet werden. Dieser ermöglicht:
- eine größere Kontaktfläche zwischen metallischer Schmelze und Schlacke
- verhindert einen Kontakt zwischen Tiegel und metallischer Schmelze und unterdrückt so ungewollte Keimbildung

Diese Wirkung der Schlacke bestimmt wesentlich die bisher nach bekannten Verfahren mit wirtschaftlich vertretbarem Aufwand nicht erreichbare hohe kristallographische und metallographische Qualität und chemische Reinheit der hergestellten Einkristalle.

Die Zusammensetzung des schlackebildenden Flussmittels muss auf das jeweilige System abgestimmt werden, sie kann nicht verallgemeinert werden. Das konkrete Verfahren zur Herstellung von Ni-Mn-Ga-Einkristallen ist nur deshalb zweistufig, weil Gallium einen extrem niedrigen Schmelzpunkt besitzt, und die ungeschmolzenen Flussmittelbestandteile im dichten, flüssigen Gallium seigem würden.

Die Erfindung ist besonders zweckmäßig zur Herstellung einkristalliner Flugzeug-Turbinenschaufeln, wobei das Erreichen besonders niedriger Schwefelkonzentrationen in den Schaufeln von höchster Bedeutung ist, da Schwefel selbst im ppm-Bereich die Hochtemperaturverschleißeigenschaften der Schaufeln erheblich beeinträchtigt (Spalling).

Die Anwendung schlackebildender Flussmittel im Kristallzüchtungstiegel, der "Formschale", verspricht hier außerordentliche Vorteile. Einerseits kann der Schwefelrestgehalt in den Schaufeln drastisch gesenkt werden. Anderseits ist der "Scrap" nun ebenfalls gereinigt und trägt beim erneuten Einschmelzen zur weiteren Senkung des Schwefelgehaltes der "Master-Melt" bei.

Die Herstellung einkristalliner Nickel- und Kobaltbasislegierungen, die kommerziell besonders interessant sind (Flugzeugturbinenbau), kann für andere Anwendungen auch in einem einstufigen Prozess, jedenfalls ohne zusätzliches Befüllen des Tiegels, erfolgen.

Für bestimmte Anwendungen kann das erfindungsgemäße Verfahren auch mit Zonenschmelzmethoden verknüpft werden, um auf einfachste Weise sehr reine, kristalline Stoffe darzustellen. Dies ist nicht auf die Züchtung von Einkristallen beschränkt.

Die Erfindung wird nachfolgend an einem Ausführungsbeispiel näher erläutert. Die zugehörige Zeichnung zeigt eine erfindungsgemäße Anordnung nach einem kombinierten ESU- und Bridgmanverfahren.

Das erfindungsgemäße Verfahren wird an einem im Labormaßstab bewährten Verfahrensablauf erläutert.
Es sollen große (mehrere ccm), poren- und einschlussfreie Ni-Mn-Ga-Einkristalle unter Vermeidung von Manganverlusten während des Schmelzens hergestellt werden.
Die hochschmelzenden Metallpulver (Nickel, Mangan, ggf. auch vorlegiertes Nickel-Mangan) werden mit einem schlackebildenden Flussmittel (z.B. 55at% MgF₂, 35at% CaF₂, 10at%CaO) innig vermengt. Diese .Mischung wird in einen Kristallzüchtungstiegel gegeben und mechanisch verdichtet, um einen hohen Füllgrad zu erreichen. Der Inhalt des Tiegels wird aufgeschmolzen, indem der Tiegel unter Schutzgas etwa 15 min bei 1300 °C erhitzt wird. Nach dem Abkühlen befindet sich im Tiegel eine Nickel-Mangan-Legierung, welche von einer festen Schlacke bedeckt ist. Nun wird das Gallium in den Tiegel gegeben. Das Gallium liegt also im Tiegel zunächst auf der Schlacke. Der Tiegel wird anschließend unter Schutzgas auf etwa 1200 °C erhitzt. Die Schlacke schmilzt und bildet eine Deckschicht um die metallische Schmelze, unter der das Gallium und die Nickel-Mangan-Legierung verschmelzen. Um eine hohe Homogenität der Schmelze zu gewährleisten, wird die Temperatur hinreichend lange gehalten, ggf. unter Agitation der Schmelze, z.B. durch Drehen des Tiegels oder Einkoppeln von Ultraschall. Auch kann die Schmelze *in situ* erstarrt und wieder aufgeschmolzen werden. Schließlich wird die Schmelze unter Anwendung eines Temperaturgradienten erstarrt, indem der Tiegel entweder durch ein Temperaturfeld bewegt oder indem das Temperaturfeld, in welchem sich der Tiegel befindet, zeitabhängig verändert wird (Bridgman-Verfahren, VGF-Verfahren).
Für dieses Verfahren kommen in erster Linie Halogenide als Flussmittelbestandteile in Frage, aber auch Oxide, v.a. stark basische, um oxidische Verunreinigungen in die entsprechenden ternären Verbindungen zu überführen sowie Silikate, Borate, Phosphate usw.

Das Verfahren kann erfindungsgemäß erheblich abgewandelt werden. Beispielsweise ist es möglich, das Elektroschlacke-Umschmelzverfahren (ESU- Verfahren) nach M. G. Benz, W. T. Carter, Jr., GE Research & Development Center (2000) für die Kristallzüchtung zu modifizieren, indem die durch eine geeignete Schlacke aufgereinigte metallische Schmelze unter der Schlacke in einem für die Kristallzüchtung der jeweiligen Substanz geeigneten Tiegel nach Fig. unter Anwendung eines Temperaturgradienten erstarrt wird.

Kennzeichnend für das oben stehenden Verfahren ist lediglich die Verwendung eines schlackebildenden Flussmittels zum Zweck der Kristallzüchtung aus metallischen Schmelzen oder Schmelzlösungen. Die eigentliche Kristallisation kann nach unterschiedlichsten Verfahren erfolgen.

Die in der Fig. dargestellte Anordnung arbeitet nach einem kombinierten ESU- und Bridgmanverfahren.
In einem elektrisch leitfähigen inerten Tiegel 5 wird zunächst festes schlackebildendes Flussmittel unter Verwendung äußerer Heizelemente 1; 2 geschmolzen. Zur thermischen Entkopplung kann zwischen den beiden Heizelementen 1; 2 eine thermische Isolierung 8 angeordnet werden. Eine die Ausgangskomponenten enthaltende polykristalline, gesinterte oder amorphe "konsumierbare" Elektrode 6 wird in die geschmolzene, ionenleitende Schlacke 4 hinein geführt. Durch Anlegen einer niederohmigen Spannungsquelle 7, vorzugsweise Wechselspannungsquelle, an die Elektrode 6 und den Tiegel 5 wird die Elektrode 6 sukzessive aufgeschmolzen. Die gereinigte metallische Schmelze 3 sammelt sich unter der Schlacke. Schließlich wird die gereinigte metallische Schmelze unter Anwendung eines Temperaturgradienten langsam erstarrt. Das Abkühlen kann durch Bewegen des Tiegels 5, Bewegen der Heizelemente 1; 2 oder Steuerung der Leistung der Heizelemente 1; 2 erfolgen.

Das erfindungsgemäße Verfahren ist nicht auf die Herstellung einkristalliner Ni-Mn-Ga-Legierungen beschränkt, sondern kann für die Kristallzüchtung zahlreicher Metalle, intermetallischer Verbindungen und Legierungen, beispielsweise Nickel- und Kobaltbasislegierungen vorteilhaft angewendet werden.

Die Erfindung ermöglicht ein einfaches und vielseitig anwendbares Verfahren zur Einkristallzüchtung aus metallischen Schmelzen oder Schmelzlösungen und Kristallisation nach bekannten Verfahren. Es können große poren- und einschlussfreie Einkristalle aus Metallen sowie intermetallischen Verbindungen und Legierungen hergestellt werden.

Chemische Verunreinigungen können gezielt aus der metallischen Schmelze oder Schmelzlösung entfernt und so chemisch besonders reine Kristall erhalten werden.

Ein Kontakt zwischen metallischer Schmelze oder Schmelzlösung und Kristallzüchtungstiegel kann vermieden werden, wodurch eine bessere Nukleationskontrolle ermöglicht wird.

Das Verfahren verhindert das Abdampfen flüchtiger Bestandteile der metallischen Schmelze oder Schmelzlösung, was im Falle von Legierungen eine bessere Kontrolle der chemischen Zusammensetzung des Kristalls und im Falle kongruent schmelzender, intermetallischer Verbindungen ein Abreißen der Kristallisation oder eine Kristallisation einer unerwünschten Phase oder die Ausbildung unerwünschter Realstrukturen verhindern kann.

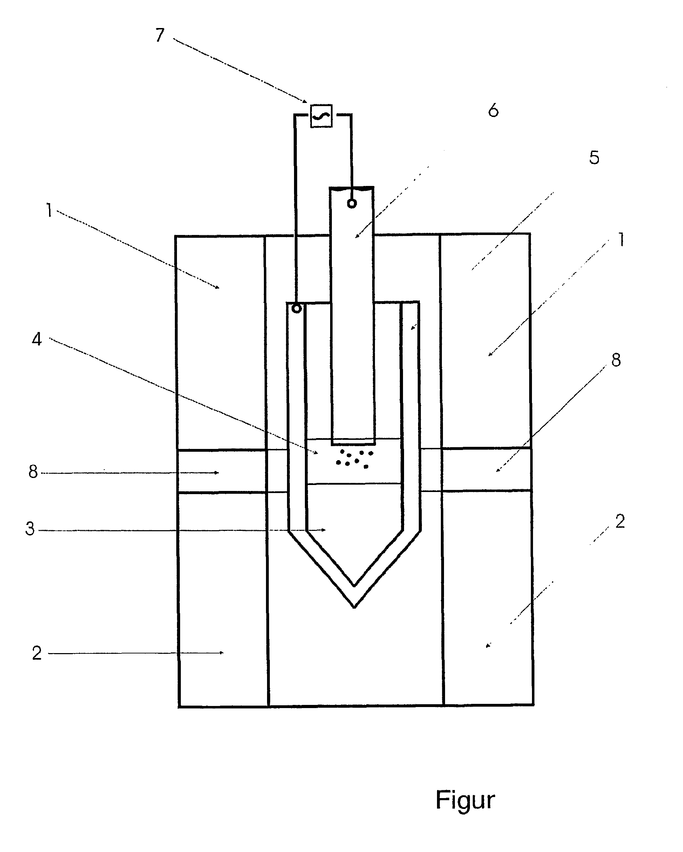

## Patentansprüche

1. Verfahren zur Züchtung von Einkristallen aus metallischen Schmelzen oder Schmelzlösungen, wobei die Kristallisation nach bekannten Verfahren erfolgt und als Ausgangsmaterialien der metallischen Schmelzen oder Schmelzlösungen Metalle oder intermetallischen Verbindungen oder Legierungen verwendet werden,
**dadurch gekennzeichnet, dass**
die Ausgangsmaterialien mit einem schlackebildenden, gegen die metallische Schmelze chemisch inerten Flussmittel innig in Kontakt gebracht und vollständig aufgeschmolzen werden, wobei die Zusammensetzung des Flussmittels derart auf das jeweilige System Kristallzüchtungstiegel - Schmelze abgestimmt wird, dass die sich bildende Schlacke den Tiegel benetzt und zwischen metallischer Schmelze und Kristallzüchtungstiegel einen geschlossenen dünnen Film bildet.

2. Verfahren nach Anspruch 1,
**dadurch gekennzeichnet, dass**
das schlackebildende Flussmittel und die Metalle oder intermetallischen Verbindungen oder Legierungen im festen Zustand gemischt und im Kristallzüchtungstiegel aufgeschmolzen werden.

3. Verfahren nach Anspruch 1,
**dadurch gekennzeichnet, dass**
das schlackebildende Flussmittel und die Metalle oder intermetallischen Verbindungen oder Legierungen voneinander räumlich getrennt aufgeschmolzen und nacheinender in den Kristallzüchtungstiegel gegeben werden.

4. Verfahren nach Anspruch 3,
**dadurch gekennzeichnet, dass**
das schlackebildende Flussmittel im Tiegel vorgelegt und die metallische Schmelze hinzu gegossen wird.

5. Verfahren nach Anspruch 1,
**dadurch gekennzeichnet, dass**
die Temperatur der Schmelze hinreichend lange konstant gehalten wird.

6. Verfahren nach Anspruch 1,
**dadurch gekennzeichnet, dass**
die Schmelze *in situ* erstarrt und wieder aufgeschmolzen wird.

7. Verfahren nach den Ansprüchen 1 bis 4,
**dadurch gekennzeichnet, dass**
der Bestandteil der Metalle oder intermetallischen Verbindungen oder Legierungen, der einen niedrigeren Solidus besitzt als die Schlacke, nach dem Aufschmelzen der übrigen Bestandteile auf die erstarrte Schlacke gegeben und das Kristallzüchtungsgefäß unter einer inerten Atmosphäre derart erhitzt wird, dass die Schlacke eine Deckschicht auf der metallischen Schmelze bildet, unter der alle metallischen Bestandteile verschmelzen.

8. Verfahren nach Anspruch 7,
**dadurch gekennzeichnet, dass**
die inerte Atmosphäre ein verminderter Druck (Vakuum) ist.

9. Verfahren nach Anspruch 1,
**dadurch gekennzeichnet, dass**
das schlackebildende Flussmittel ein hohes Lösungsvermögen für die jeweiligen, zumeist oxidischen, Verunreinigungen besitzt.

10. Verfahren nach den Ansprüchen 1 und 9,
**dadurch gekennzeichnet, dass**
der Solidus der Schlacke kleiner ist als der Schmelzpunkt bzw. die Schmelzpunkte der in der metallischen Schmelze oder Schmelzlösung enthaltenen Metalle.

11. Verfahren nach Anspruch 10,
**dadurch gekennzeichnet, dass**
der Solidus des Schlackesystems kleiner als der Solidus der metallischen Schmelze oder Schmelzlösung ist.

12. Verfahren nach den Ansprüchen 1 und 9 bis 11,
**dadurch gekennzeichnet, dass**
die Dichte der Schlacke kleiner als die der metallischen Schmelze oder Schmelzlösung ist.

13. Verfahren nach den Ansprüchen 1 und 9 bis 12,
**dadurch gekennzeichnet, dass**
die Viskosität der Schlacke an die jeweilige Aufgabe angepasst ist.

14. Verfahren nach den Ansprüchen 1 und 9 bis 13,
**dadurch gekennzeichnet, dass**
Halogenide, Oxide, Silikate, Borate, Phosphate Flussmittelbestandteile sind.

15. Verfahren nach den Ansprüchen 1 und 9 bis 14,
**dadurch gekennzeichnet, dass**
das schlackebildende Flussmittel aus 55 at% MgF₂, 35 at% CaF₂ und 10 at% CaO besteht.

16. Verfahren nach Anspruch 1,
**dadurch gekennzeichnet, dass**
die Ausgangsmaterialien in Form einer konsumierbaren Elektrode verwendet werden, das Aufschmelzen dieser Elektrode nach dem ESU-Verfahren und das Erstarren der Schmelze nach dem Bridgman-Verfahren erfolgt.

17. Verfahren nach Anspruch 15 und 16,
**dadurch gekennzeichnet, dass**
Ni-Mn-Ga-Einkristalle in einem kombinierten Elektroschlacke-Umschmelz- und Bridgman-Verfahren hergestellt werden, bei dem
- Nickel- und Manganpulver oder vorlegiertes Nickel-Mangan-Pulver und ein schlackebildendes Flussmittel aus 55 at% MgF₂, 35 at% CaF₂ und 10 at% CaO im Kristallzüchtungstiegel innig vermischt werden,
- der Tiegelinhalt aufgeschmolzen und wieder abgekühlt wird,
- Gallium zugegeben wird und der Tiegelinhalt wieder geschmolzen wird,
- die Schmelze unter Anwendung eines Temperaturgradienten erstarrt wird.

18. Verfahren nach Anspruch 1,
**dadurch gekennzeichnet, dass**
der Temperaturgradient beim Erstarren mittels eines bewegbaren Kristallzüchtungstiegels eingestellt wird.

19. Verfahren nach Anspruch 1,
**dadurch gekennzeichnet, dass**
der Temperaturgradient beim Erstarren mittels bewegbarer Heizelemente eingestellt wird.

20. Verfahren nach Anspruch 1,
**dadurch gekennzeichnet, dass**
der Temperaturgradient beim Erstarren mittels elektrisch steuerbarer Heizelemente eingestellt wird.

## Claims

1. Method for growing single crystals from fused metals or fused solutions, with the crystallization being effected in accordance with known methods, and metals or intermetallic compounds or alloys being used as the starting materials of the fused metals or fused solutions,
**characterised in that**
the starting materials are brought into intimate contact with a slag-forming flux, which is chemically inert with respect to the fused metal, and are completely melted down, with the composition of the flux being matched to the respective system crystal-growing crucible - melt in such a way that the slag that forms wets the crucible and forms a closed thin film between the fused metal and the crystal-growing crucible.

2. Method according to claim 1,
**characterised in that**
the slag-forming flux and the metals or intermetallic compounds or alloys are mixed in the solid state and melted down in the crystal-growing crucible.

3. Method according to claim 1,
**characterised in that**
the slag-forming flux and the metals or intermetallic compounds or alloys are melted down separately from each other spatially and delivered into the crystal-growing crucible one after the other.

4. Method according to claim 3,
**characterised in that**
the slag-forming flux is placed in the crucible and the fused metal is additionally poured in.

5. Method according to claim 1,
**characterised in that**
the temperature of the melt is kept constant for a sufficiently long time.

6. Method according to claim 1,
**characterised in that**
the melt solidifies *in situ* and is melted down again.

7. Method according to claims 1 to 4,
**characterised in that**
the constituent of the metals or intermetallic compounds or alloys that has a lower solidus than the slag is delivered after the remaining constituents have melted down onto the solidified slag, and the crystal-growing vessel is heated in an inert atmosphere in such a way that the slag forms a covering layer on the fused metal underneath which all the metallic constituents melt.

8. Method according to claim 7,
**characterised in that**
the inert atmosphere is a reduced pressure (vacuum).

9. Method according to claim 1,
**characterised in that**
the slag-forming flux has a high dissolving capacity for the respective, mostly oxidic impurities.

10. Method according to claims 1 and 9,
**characterised in that**
the solidus of the slag is lower than the melting point or the melting points of the metals contained in the fused metal or fused solution.

11. Method according to claim 10,
**characterised in that**
the solidus of the slag system is lower than the solidus of the fused metal or fused solution.

12. Method according to claims 1 and 9 to 11,
**characterised in that**
the density of the slag is lower than that of the fused metal or fused solution.

13. Method according to claims 1 and 9 to 12,
**characterised in that**
the viscosity of the slag is matched to the respective task.

14. Method according to claims 1 and 9 to 13,
**characterised in that**
halides, oxides, silicates, borates, phosphates are flux constituents.

15. Method according to claims 1 and 9 to 14,
**characterised in that**
the slag-forming flux consists of 55 at% MgF₂, 35 at% CaF₂ and 10 at% CaO.

16. Method according to claim 1,
**characterised in that**
the starting materials are used in the form of a consumable electrode, the meltdown of this electrode is effected in accordance with the electroslag remelting process, and the solidification of the melt is effected in accordance with the Bridgman process.

17. Method according to claim 15 and 16,
**characterised in that**
Ni-Mn-Ga-single crystals are produced in a combined electroslag remelting and Bridgman process, in which
- nickel and manganese powder or pre-alloyed nickel-manganese powder and a slag-forming flux consisting of 55 at% MgF₂, 35 at% CaF₂ and 10 at% CaO are intimately mixed in the crystal-growing crucible,
- the crucible content is melted down and recooled,
- gallium is added and the crucible content is re-melted,
- the melt is solidified with application of a temperature gradient.

18. Method according to claim 1,
**characterised in that**
the temperature gradient upon solidification is adjusted by means of a movable crystal-growing crucible.

19. Method according to claim 1,
**characterised in that**
the temperature gradient upon solidification is adjusted by means of movable heating elements.

20. Method according to claim 1,
**characterised in that**
the temperature gradient upon solidification is adjusted by means of electrically controllable heating elements.

## Revendications

1. Procédé de développement de monocristaux à partir de bains ou de solutions fondues de métaux, la cristallisation se faisant selon les procédés connus et les matières premières des bains ou solutions fondues métalliques étant des métaux ou des combinaisons intermétalliques ou des alliages,
**caractérisé en ce qu'**
on met les matières premières en contact intime avec un fondant chimiquement inerte vis-à-vis du bain métallique et qui forme des scories, puis on fait fondre complètement,
la composition du fondant est définie en fonction du système respectif constitué par le creuset de développement du cristal et le bain afin que les scories qui se développent mouillent le creuset et forment un film mince fermé, entre le bain métallique et le creuset de développement du cristal.

2. Procédé selon la revendication 1,
**caractérisé en ce qu'**
on mélange le fondant formant des scories et les métaux ou les combinaisons intermétalliques ou les alliages, à l'état solide et on fait fondre dans le creuset de développement du cristal.

3. Procédé selon la revendication 1,
**caractérisé en ce qu'**
on fait fondre de manière séparée dans l'espace, le fondant formant des scories et les métaux ou les combinaisons intermétalliques ou les alliages et on les ajoute successivement dans le creuset de développement du cristal.

4. Procédé selon la revendication 3,
**caractérisé en ce que**
le fondant formant des scories est mis d'abord dans le creuset et on ajoute ensuite le bain métallique.

5. Procédé selon la revendication 1,
**caractérisé en ce qu'**
on maintient la température du bain à un niveau constant suffisamment longtemps.

6. Procédé selon la revendication 1,
**caractérisé en ce que**
le bain *in situ* est de nouveau fondu.

7. Procédé selon les revendications 1 à 4,
**caractérisé en ce que**
la partie constitutive des métaux ou des combinaisons intermétalliques ou des alliages ayant un solidus plus bas que les scories, est ajoutée après fusion des autres composants aux scories qui se figent et on chauffe le récipient de développement du cristal sous une atmosphère inerte pour que les scories constituent une couche couvrant le bain métallique, couche sous laquelle tous les composants métalliques fondent.

8. Procédé selon la revendication 7,
**caractérisé en ce que**
l'atmosphère inerte est une pression réduite (vide).

9. Procédé selon la revendication 1,
**caractérisé en ce que**
le fondant formant des scories possède une capacité élevée de dissolution pour les impuretés respectives, généralement oxydantes.

10. Procédé selon les revendications 1 et 9,
**caractérisé en ce que**
le solidus des scories est inférieur au point de fusion ou aux points de fusion du bain métallique ou de la solution contenant des métaux.

11. Procédé selon la revendication 10,
**caractérisé en ce que**
le solidus du système de scories est plus petit que le solidus du bain métallique ou de la solution fondue.

12. Procédé selon les revendications 1 et 9 à 11,
**caractérisé en ce que**
la densité des scories est inférieure à celle du bain métallique ou de la solution fondue.

13. Procédé selon les revendications 1 et 9 à 12,
**caractérisé en ce que**
la viscosité des scories est adaptée au problème respectif.

14. Procédé selon les revendications 1 et 9 à 13,
**caractérisé en ce que**
les composants du fondant sont des halogénures, des oxydes, des silicates, des borates et des phosphates.

15. Procédé selon les revendications 1 et 9 à 14,
**caractérisé en ce que**
le fondant formant des scories se compose de 55 % atomiques de MgF₂, 35 % atomiques de CaF₂ et 10 % atomiques de CaO.

16. Procédé selon la revendication 1,
**caractérisé en ce que**
les matières premières sont utilisées sous la forme d'une électrode consommable, la fusion de cette électrode se fait selon le procédé ESU et le figeage du bain se fait selon le procédé Bridgman.

17. Procédé selon les revendications 15 et 16,
**caractérisé en ce qu'**
on fabrique des monocristaux Ni-Mn-Ga selon un procédé combiné de fusion électrique de scories et du procédé Bridgman selon lequel :
- on fait un mélange intime, dans le creuset de développement du cristal, de poudre de nickel et de manganèse ou d'une poudre nickel-manganèse existante et d'un fondant formant des scories composé de 55 % at de MgF₂, 35 % at de CaF₂ et 10 % at de CaO dans le creuset de développement du cristal en procédant à un mélange intime,
- on fait fondre le contenu du creuset et on refroidit de nouveau,
- on ajoute du gallium et on fait de nouveau fondre le contenu du creuset, et
- on laisse figer le bain en utilisant un gradient de température.

18. Procédé selon la revendication 1,
**caractérisé en ce qu'**
on règle le gradient de température lors du figeage à l'aide d'un creuset mobile de développement de cristaux.

19. Procédé selon la revendication 1,
**caractérisé en ce qu'**
on règle le gradient de température lors du figeage à l'aide d'éléments chauffants mobiles.

20. Procédé selon la revendication 1,
**caractérisé en ce qu'**
on règle le gradient de température lors du figeage par des éléments chauffants à commande électrique.
